(19) **Europäisches Patentamt**
**European Patent Office**
**Office européen des brevets**

(11) **EP 3 663 943 A1**

(12) **EUROPEAN PATENT APPLICATION**

(43) Date of publication:
**10.06.2020 Bulletin 2020/24**

(51) Int Cl.:
***G06F 17/50*** *(2006.01)*

(21) Application number: **18211171.6**

(22) Date of filing: **07.12.2018**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Hitachi, Ltd.**
**Tokyo 100-8280 (JP)**

(72) Inventors:
- **MOFFA, Giulio**
  **London, EC2Y 5AJ (GB)**
- **SUKEGUCHI, Satoshi**
  **London, EC2Y 5AJ (GB)**
- **YANG, Jiannan**
  **London, EC2Y 5AJ (GB)**

(74) Representative: **Mewburn Ellis LLP**
**Aurora Building**
**Counterslip**
**Bristol BS1 6BX (GB)**

(54) **METHOD AND SYSTEM FOR DESIGNING A RAIL VEHICLE INTERIOR BASED ON SIMULATION OF ACOUSTIC NOISE**

(57)     A method of designing the interior arrangement of a rail vehicle, the method comprising the steps of providing a simulated rail vehicle with an interior space; arranging one or more simulated elements within the interior space; providing an acoustic noise distribution for the interior space on the basis of at least the simulated elements and their arrangement within the interior space; providing a representation of the acoustic noise at one or more locations within the interior space.

*Figure 13*

EP 3 663 943 A1

**Description**

*Field of the Invention*

The present invention relates to the design of the interior of a rail vehicle, in particular by providing a representation of the acoustic noise experienced at one or more locations within the interior according to the chosen configuration of the elements arranged within the interior.

*Background*

Rail vehicle interiors typically have a significantly shorter life-span than the train itself. Rail vehicle interiors are therefore periodically refitted due to changes of train operating company or branding, need for modernisation, or to account for general wear. When designing new rail vehicle interiors, a common approach is to use computer-based configurators, since this allows the designer to visualise different arrangements e.g. prior to fitting the interior of the rail carriages. For example US2007/0233433A discloses arranging interior elements for aircraft according to their 3D space requirements. US2016/0110916A and US2009/0216502A disclose configuration and display of interior spaces for configuration of buildings, aircraft, and trains.

However, while these disclosures can provide a visual representation of the configured space, they do not provide the designer with a complete understanding of the design considerations. Specifically, they do not allow the designer to understand fully how changes in the configuration will affect the overall user experience in the space when subsequently manufactured and used.

The present inventors have understood that acoustic noise levels in vehicles, particularly public transport such as rail vehicles (e.g. trains or trams) can affect greatly the user experience. Further, the present inventors have appreciated that different arrangements (configurations) of interior fittings, as well as choice of materials and construction of such interior fittings, can greatly impact how sound propagates and attenuates through a space, e.g. a rail vehicle (carriage) interior, and therefore affect the user's perception of acoustic noise, e.g. at different locations.

In light of the above, the present invention aims to provide the designer of a rail vehicle with a representation of the acoustic noise levels within the interior space of the rail vehicle. Preferably the present invention provides a representation of how the acoustic noise levels are affected e.g. by the type, location, and construction/material of the interior fittings; more preferably, particularly how the specific interior configurations can affect the overall user experience in the subsequently manufactured rail vehicle when in use.

*Summary of the Invention*

The present invention provides a method of designing the interior arrangement of a rail vehicle, the method comprising the steps of providing a simulated rail vehicle with an interior space, arranging one or more simulated elements within the interior space, providing an acoustic noise distribution for the interior space on the basis of at least the simulated elements and their arrangement within the interior space, and providing a representation of the acoustic noise at one or more locations within the interior space.

Optionally, the invention provides a method further comprising the step of providing a model of one or more sources of acoustic noise, wherein the step of providing the acoustic noise distribution includes the step of generating the acoustic noise distribution for the interior space on the basis of at least the model, the simulated interior elements and their arrangement within the interior space.

Optionally, the invention provides a method further comprising the step of selecting a location within the interior space, and providing the representation of the acoustic noise at the selected location.

Optionally, the provided representation of the acoustic noise is an audible representation or a visual representation, or both an audible and a visual representation of the acoustic noise.

Optionally, the provided representation further includes a visual representation of at least the interior space, the simulated elements, and their arrangement.

Optionally, the one or more sources of acoustic noise may be external to the interior space, or internal to the interior space.

Optionally, the transmission of acoustic noise from sources that are external to the interior into the interior space is modelled via a carbody vibration model.

Optionally, the acoustic noise distribution for the interior space is calculated via a ray-tracing method based on the carbody vibration model for acoustic noise sources external to the interior space and/or one or more acoustic noise sources internal to the interior space.

Optionally, the ray-tracing method utilises one or more sound absorption coefficients corresponding to the one or more simulated interior elements.

Optionally, the one or more sound absorption coefficients have different values depending on the frequency of the acoustic noise.

Optionally, the acoustic noise distribution is further based on one or more sound absorption coefficients for aside from those for the one or more simulated interior elements.

Optionally, the volume and/or frequency of the one or more sources of acoustic noise can be changed.

Optionally, the acoustic noise distribution and/or models of one or more sources of acoustic noise and/or one or more sound absorption coefficients are based on representative measured data of rail vehicles and/or fixtures and fittings and/or construction materials thereof.

Optionally, the acoustic noise distribution is based on representative measured data of rail vehicles and/or fixtures and fittings and/or construction materials thereof. Optionally, the models of one or more sources of acoustic noise are based on representative measured data of rail vehicles and/or fixtures and fittings and/or construction materials thereof. Optionally, the one or more sound absorption coefficients are based on representative measured data of rail vehicles and/or fixtures and fittings and/or construction materials thereof.

The present invention also provides a computer program comprising computer program code which, when run on a computer, executes any one of the methods described herein. The present invention also provides a computer readable medium storing the computer program (product). For example, the present invention provides the computer program embodied on a computer readable medium.

Further, the present invention provides a system for designing the interior arrangement of a rail vehicle, comprising input means operable (e.g. by a user) to arrange one or more simulated elements within an interior space of a simulated rail vehicle, a processor configured to provide an acoustic noise distribution for the interior space based on the simulated elements and their arrangement within the interior space, and output means configured to provide (e.g. to the user) a representation of the acoustic noise at the selected location.

Optionally, the processor may be configured to provide the acoustic noise distribution for the interior space based on the simulated elements and their arrangement within the interior space, and on a model of one or more sources of acoustic noise. The system may further comprise input means operable to select (or configure) the model of one or more sources of acoustic noise.

Optionally, the system further comprises input means operable to select a location within the interior space. The output means preferably provides a representation of the acoustic noise at the selected location.

Optionally, the system provides an audible representation of the acoustic noise. The system may provide a visual representation of the acoustic noise. The system may provide an audible and a visual representation of the acoustic noise.

Optionally, the system further provides a visual representation of at least the interior space, the simulated elements, and their arrangement.

The invention includes the combination of the aspects and preferred features described except where such a combination is clearly impermissible or expressly avoided.

### *Summary of the Figures*

Embodiments illustrating the principles of the invention will now be discussed with reference to the accompanying figures in which:

**Figure 1** shows a hardware structure of an embodiment of the present invention.

**Figure 2** shows an example of the train configurator screen used to select a train type.

**Figure 3** shows an example of the input parameters which can be used to generate a train configuration.

**Figure 4** shows one example of the Home screen of the train configurator.

**Figure 5** shows an example of the train configurator screen used to select whole train parameters such as number of carriages, number of standard class carriages and first class carriages.

**Figure 6** shows an example configuration screen for a standard class carriage

**Figure 7** shows an example method for measuring acoustic noise levels generated by a moving train through the use of track-side microphones.

**Figure 8** shows example data for measured roughness of different rail types.

**Figure 9** shows an example for considering a vibrating rail as a series of point acoustic sources.

**Figure 10** shows an example input to a carbody vibration model for the transmission of wheel-based vibrations to the rail vehicle.

**Figure 11** shows an example carbody vibration model, where the carbody is viewed as an array of surface sound sources.

**Figure 12** shows an example of the predicted interior acoustic noise levels from the carbody vibration model, and comparison with real-world measurements.

**Figure 13** shows an example input to a ray-tracing algorithm for modelling acoustic noise propagation inside the configured rail vehicle.

**Figure 14** shows an example method for measuring the reverberation time for the rail vehicle interior.

**Figure 15** shows an example calculated acoustic noise distribution for a rail vehicle interior.

### Detailed Description of the Invention

Aspects and embodiments of the present invention will now be discussed with reference to the accompanying figures. Further aspects and embodiments will be apparent to those skilled in the art. All documents mentioned in this text are incorporated herein by reference.

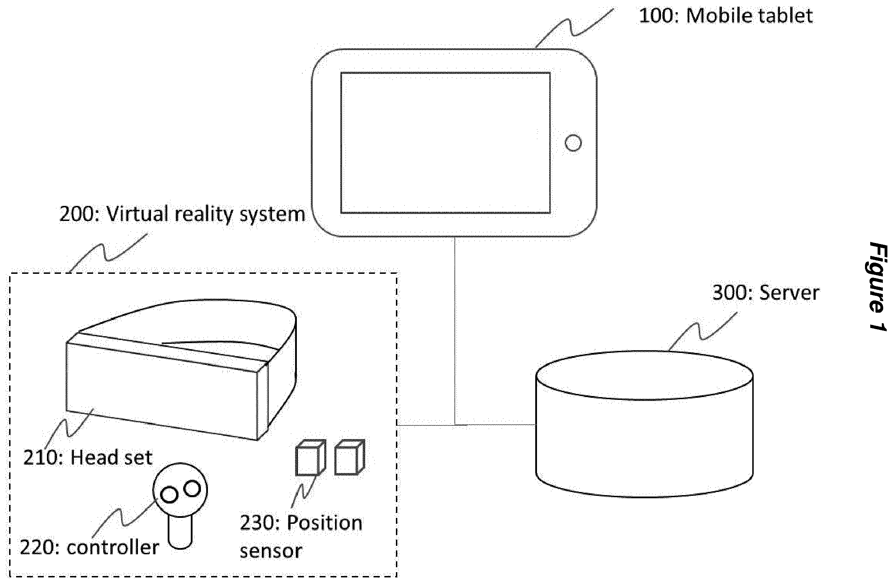

Figure 1 shows an exemplary hardware structure of an embodiment of the present invention. It has a mobile tablet 100, virtual reality (VR) system 200, and server 300.

The mobile tablet has a touch panel to input configuration and to display selected configuration of the train. This embodiment shows examples using the mobile tablet 100. A computer (e.g. a personal computer, PC), or other equipment having display and input devices can be used instead of the mobile tablet 100.

The VR system 200 has a head set 210 to display 3D VR images, a controller 220 to modify parameters of the train configuration, and a position sensor 230 to detect location and direction of the head set 210 and controller 220. A PC, or other equipment having audible and/or visual outputs can be used instead of the VR system 200.

The server 300 has functions to store information of train configurations which are created by the mobile tablet 100. The server may have functions to model the sound levels inside a train carriage with the selected configuration. It may also be used, for example, to create a real time 3D audible representation of the acoustic noise distribution in the interior space, and visual representation of the interior space, simulated elements, and their arrangement to be displayed on the head set 210. Alternatively, it may generate an alternative form of representation of the acoustic noise for distribution at locations within the rail vehicle interior space, including a visual and/or audible representation of the acoustic noise, either with or without a visual representation of the interior space, simulated elements, and their arrangement.

The server 300 can be connected with the mobile tablet 100 and the VR system with wired or wireless connection. Alternatively, one or more of the mobile tablet 100, VR system 200 and server 300 may be comprised in a single system, for example a PC.

### Train configurator

The operation of the mobile tablet 100 to design and modify train configurations will now be explained.

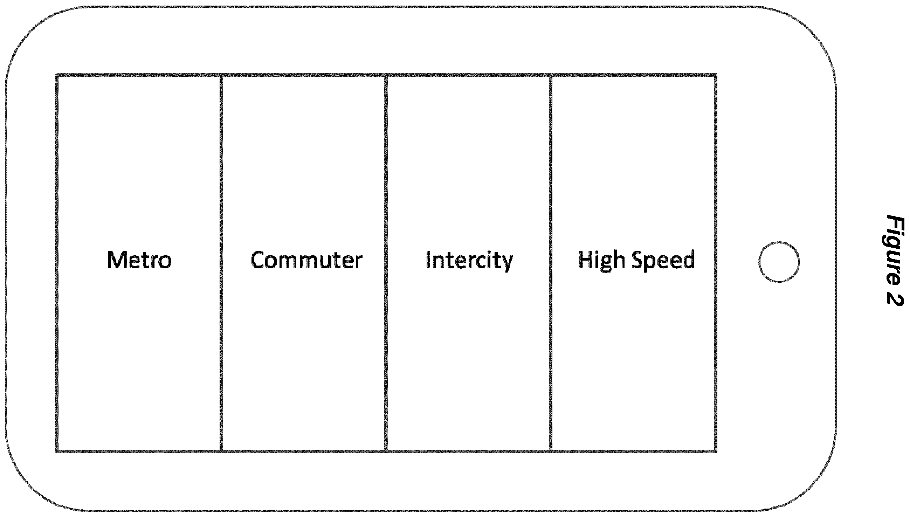

Figure 2 shows one example of the screen of the train configurator to select train type. In this example, the train configurator has four options for the train type to configure, including "High speed train", "Intercity train", "Commuter train", and "Metro train". The mobile tablet 100 displays these four options to select on its touch panel. More or fewer options may be provided.

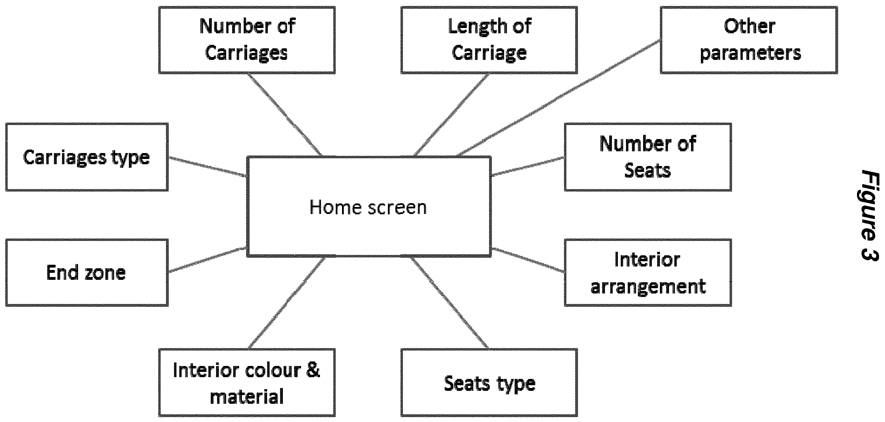

Figure 3 shows an example of the input parameters which can be used to generate the train configuration. These input parameters include length of carriage, number of carriages, carriages type, end zone type (e.g. driver cab, luggage/bicycle/equipment storage, aerodynamic shaping), interior colour & material, seats type, interior arrangement, number of seats and other parameters. Other parameters may also be included in the list of configurable options.

All the parameter input screens of the mobile tablet have a "save" icon to save selected configuration. When the "save" command is inputted by the icon, the train configuration information is transmitted to the server 300 and saved at the memory in the server 300. A saved train configuration on the server can be downloaded, transferred or loaded to the mobile tablet 100 and seen on the display.

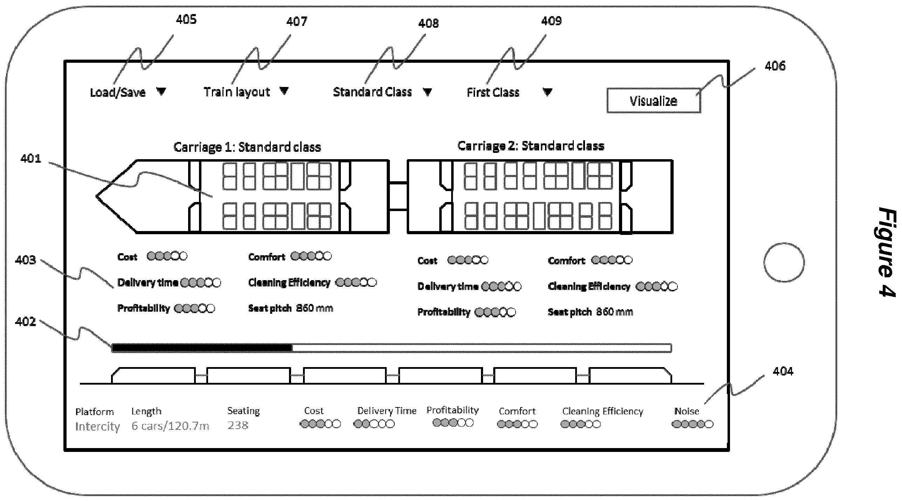

Figure 4 shows one example of the Home screen of the train configurator.

This is an example for configuration of an "intercity" train type. One or more basic parameters, for example carriage dimensions, wheel types, propulsion systems, ventilation systems, door and window locations may be set as a default configuration, and the information of the default configuration shown on the Home screen. Alternatively, the user may configure the rail vehicle without reference to a default configuration.

The Home screen has a section 401 showing seats and other interior layout. This exemplary screen shows standard class seat arrangement of carriage 1 and 2. The display may show more or fewer carriages.

The scroll bar 402 shows carriages which seat arrangements are being showed on the screen. The bar can be moved by user to select carriages for which a detailed seat arrangement is shown on the screen.

The screen may also have a section 403 showing Key Performance Indicators (KPIs) of each carriage. These allow interpretation of the effect of train configuration on parameters such as cost to provide the carriage, delivery time considering required manufacturing lead-time, profitability considering seat number, comfort considering seat pitch and seat type, cleaning efficiency considering seat number and seat type, and seat pitch. Different KPIs for the carriage, for example noise levels, may also be calculated and displayed. The KPIs may be calculated by the mobile tablet 100 or server 300. Alternatively, KPIs for the carriage may not be provided in this manner.

The screen may also have section 404 showing KPIs of whole train set which is created from selected parameters of the whole train set. The KPIs in this example for the train as a whole include are similar to those for each carriage, but also include an indication of the noise levels, the modelling of which is described in greater detail later. Different KPIs for the train may also be calculated and displayed. The KPIs may be calculated by the mobile tablet 100 or server 300. Alternatively, KPIs for the train may not be provided in this manner.

The screen also has a "Load/Save" pull down button in section 405 to save a created train configuration to the memory in the server 300, and to load a train configuration from the memory in the server 300.

The screen may also have section 406 to cause the server to provide at least the acoustic noise distribution of the configured rail vehicle to the VR headset 210 or other output means, as described in greater detail below.

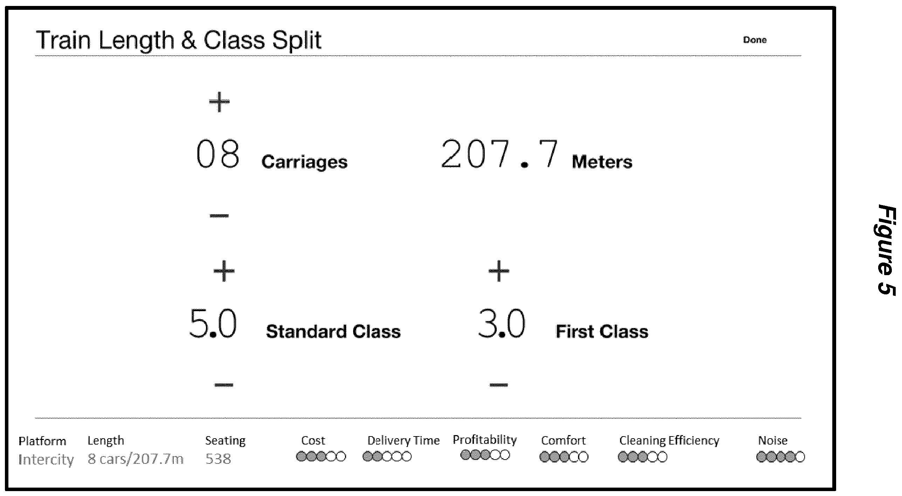

The screen also has section 407 to select whole train parameters such as number of carriages, number of standard class carriages and first class carriages, and total length of the train set. An example configuration screen for this is as shown in Figure 5. The screen may have buttons to increase or decrease the number of carriages, number of first class carriages, number of standard class carriages and length of train set. This screen may also show KPIs as for the home screen, including e.g. length of the train set, total seating number, cost of the train set, delivery time, profitability, comfort, cleaning efficiency, and noise. When the number of carriages in the train set, number of standard class carriages and first class carriages are changed, for example by clicking the buttons, these parameters are calculated/created by the mobile tablet 100 or the server 300 and displayed on this screen. For example, when carriage number is changed, length of train set, cost, delivery time, profitability and/or noise will potentially be changed. Similarly, when number of standard and first class carriages is changed, number of seating, cost, delivery time, profitability, comfort, cleaning efficiency and/or noise will potentially be changed.

The number of carriage classes and carriage types may be more or less than shown in this example. For example, a train may also include luggage, buffet, or power cars, and may also have carriages with a split of both first class and standard class seats (and/or alternative classes). Alternatively, the configuration may make no reference to class, and instead be freely configurable by the user.

The screen may also have "Standard class" pull down button in section 408 and "First class" pull down in section 409 to select standard and first class carriage parameters including number of seats, tables, bays and racks, seats type and interior colour & material. When the "Standard class" pull down button is selected in section 408 or the "First class" pull down button is selected in section 409, a menu appears with different options, allowing the interior layout, seat materials and the like to be configured. More or fewer carriage types or carriage classes may also be provided.

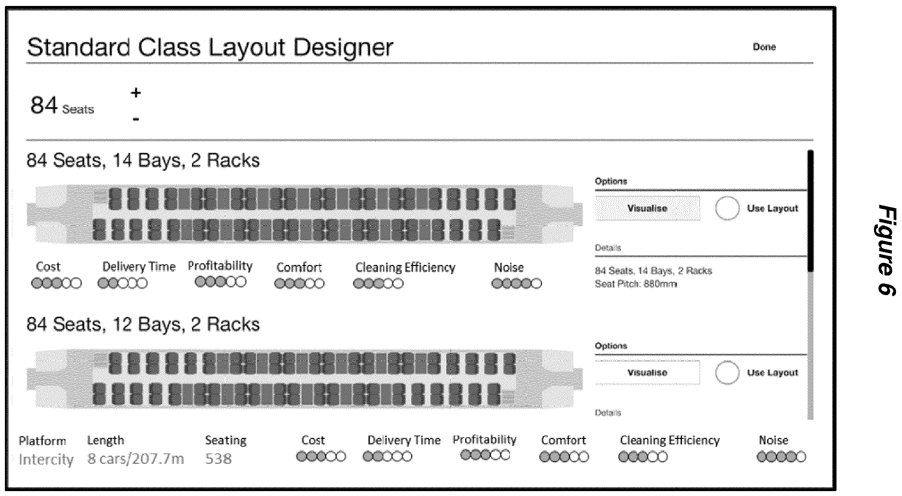

Figure 6 shows an example configuration screen for a standard class carriage. Parameters including the seat number of the carriage. Multiple interior layout options may be displayed. The KPIs from the home screen may also be shown on this screen. The screen may have buttons to increase and decrease the seat number of the carriages, to select different interior layouts, to visualise each layout option, for example as a 3D image, and/or to save a selected interior layout option. Possible layouts may be generated automatically from templates based on parameters such as the carriage length and number of seats, or may be user configured.

The selected layout for each carriage, and for the train as a whole, are used as input parameters for the acoustic noise model, allowing the interior acoustic noise levels to be calculated and simulated.

As such, the KPI of noise, generally meaning the acoustic noise level within the carriage saloon, is dependent on at least the number of seats and/or the construction of the seats, for example the materials used. For example, in the case the "number of seats" is increased, the "noise" is decreased because seats absorb the noise. Further, the KPI of "noise" also can be changed depending on the construction of the seats, for example the materials used.

Acoustic noise level modelling

The process of generating the acoustic noise level model for the configured train interior will now be described.

The method for generating an acoustic noise level model for a train interior comprises the steps of:

1) estimating/measuring acoustic noise sources strengths;
2) Developing a numerical model for transmission from external acoustic noise sources into the rail vehicle, such as a carbody vibration model;
3) Developing an acoustic model of the interior layout using a method such as a ray-tracing method. Ray tracing methods trace the sound rays from the radiation of carbody vibration for external acoustic noise, and/or from internal acoustic noise sources, considering reflection/absorption from detailed geometries of the interior layout;
4) Simulating the detailed sound distribution map inside the train.

If the train configuration is changed, as described above, the acoustic model in step 3 can be recalculated to reflect the altered sound propagation. Therefore, the model allows the effect of design details to be accounted for and included in a representation of the interior acoustic noise. The acoustic model may be calculated in advance for one or more default/predetermined rail vehicle configurations, or may be recalculated for each train configuration. There may also be a combination of these two methods, for example with acoustic models for standard configurations calculated in advance, and acoustic models for non-standard configurations calculated as required. Calculation may take place whenever a train configuration is saved, whenever a train configuration is updated, or via user input (for example by pressing a "visualise" button).

Acoustic noise source estimation

Sources of acoustic noise that can be heard from within a train interior include rolling noise of the wheels on the rail, aerodynamic/wind noise, equipment noise, and environmental noise.

Equipment noise sources can include, for example, propulsion and ventilation systems, catering equipment, and passenger address systems. Acoustic noise levels can be estimated from manufacturer specifications, or by measurement. Acoustic noise levels from external equipment can be input into the carbody vibration model to simulate the acoustic noise level transmitted to the interior of the vehicle. Acoustic noise from internal equipment can be introduced into the ray-tracing model (since the noise is not transmitted through the body of the rail vehicle).

Environmental noise includes sound sources external to the train. These may include, for example, echoes from surrounding structures such as buildings, tunnels and/or other trains, noise from weather such as wind and/or rain, and rolling and aerodynamic noise from other trains.

Aerodynamic noise can be simulated using computational fluid dynamics models or from measured data in a wind tunnel using a scaled model. For example, many sound sensors can be installed outside a 1/10 scaled vehicle. The sound levels can then me measured for each wind speed when the 1/10 scaled vehicle is in a wind tunnel, and the noise level (dB) and frequency (f) of actual vehicle can be calculated by the measured sound data and scaled model. The coefficient for converting from the scaled model can be made as a correlation table based on actual measured data.

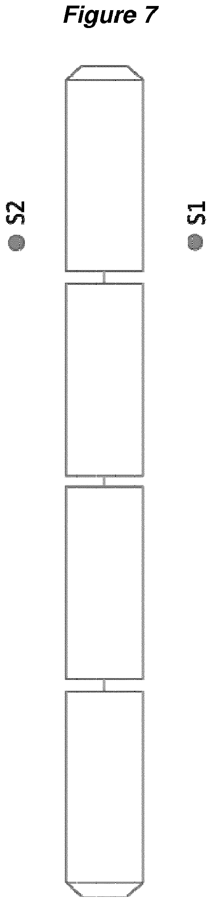

Alternatively, aerodynamic noise can be measured by measurement of a real vehicle. The external noise can be measured by using microphones (S1, S2) arranged at both sides of a track, as shown in the example in Figure 7. The noise level and peak frequency can be measured for a range of vehicle speeds. For example, 100, 125, 150, 175, 200 km/h, as shown in Table 1.

*Table 1*

| Train Speed (km/h) | S1 (dB) | | S2 (dB) | |
|---|---|---|---|---|
| | Noise level (dB) | Frequency (Hz) | Noise level (dB) | Frequency (Hz) |
| 100 | 73 | 250 | 74 | 250 |
| 125 | 77 | 312 | 77 | 312 |
| 150 | 82 | 375 | 82 | 375 |
| 175 | 87 | 437 | 88 | 437 |
| 200 | 90 | 501 | 91 | 501 |

As with equipment noise, the calculated aerodynamic noise can be used as an excitation source for the carbody vibration model.

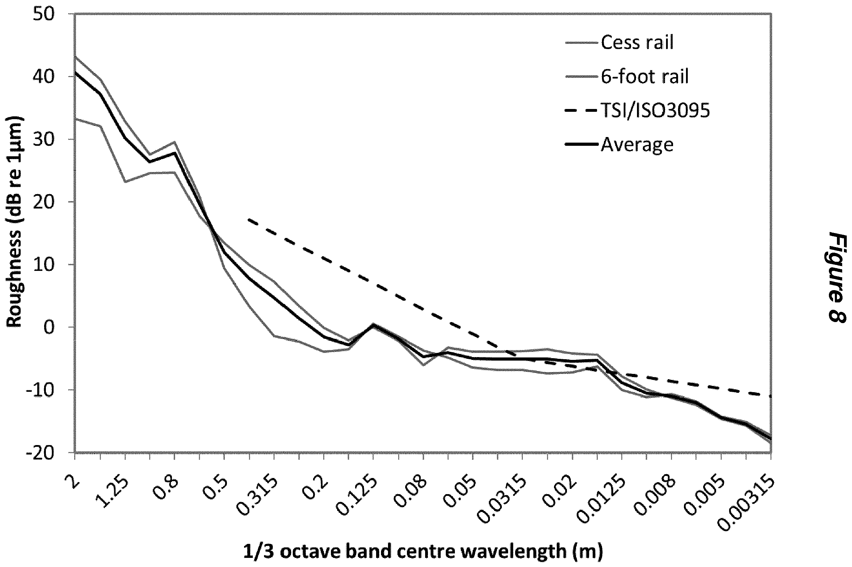

Rolling noise is one of the dominant underfloor acoustic noise sources, especially for the middle position in coaches. Rolling noise is caused by very small amplitude undulations of the wheel and rail running surfaces. Typically, on both surfaces, there are undulations with amplitudes ranging from less than 1 mm up to tens of mm. The undulations of importance for acoustic noise have wavelengths of several centimetres. An irregularity of wavelength $\lambda$ (m) causes vibration with a frequency $f = v / \lambda$, where $v$ is the train speed in m/s. Typical roughness as measured for different rail types is shown in Figure 8.

The prediction model for exterior noise caused by rolling noise has been well developed and widely used in the industry. For example "Thompson, D J., Railway Noise and Vibration - Mechanism Modelling and Means of Control., Elsevier, Oxford, 2009", and "Kitagawa T, Thompson D J., The horizontal directivity of acoustic noise radiated by a rail and implications for the use of microphone arrays, Journal of Sound and Vibration, Volume 329, Issue 2, 18 January 2010" describe modelling of vibration noise in rail vehicles.

Considering the rail as a beam-like waveguide structure, the vibration response at arbitrary position $x$ along the rail caused by point excitation at $x=0$, for certain wave type, can be calculated as

$$u_i(x) = u_i(0)e^{-k_i|x|}$$

where $k_i$ is the complex wavenumber.

The total response of the rail, in vertical or lateral directions, can be obtained as the sum of the propagating and nearfield waves:

$$u(x) = \sum_{i=1}^{2} u_i(0)e^{-k_i|x|}$$

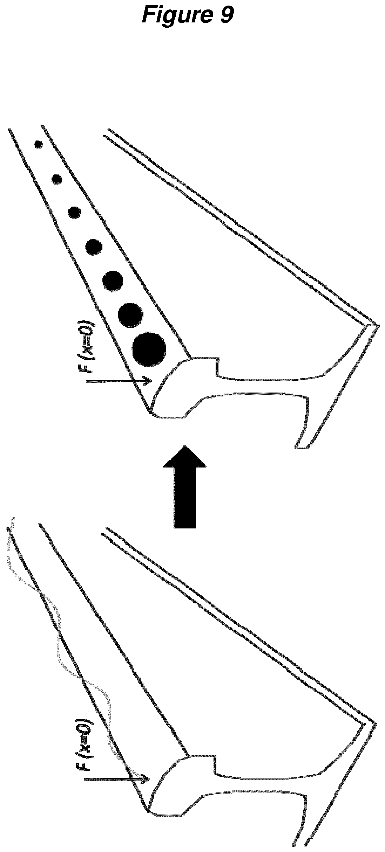

To study the interior noise caused by rolling noise, it is important to consider distributed noise sources along the track. For this purpose, the vibrating rail is replaced by a line array of acoustic point sources of suitable source strength arranged along the centre line of the rail, as indicated in Figure 9.

The sound power of these point sources can then be estimated. For a point monopole source, the sound power is given as the integral of the sound intensity of the surface of a sphere:

$$W_i = I(a)4\pi a^2 = \frac{1}{2}\mathrm{Re}(U(k,a)p(k,a)^*)4\pi a^2$$

For a line of monopole sources, the total sound power is the sum from the individual sources:

$$W_{tot} = \sum_{i=1}^{N} W_i$$

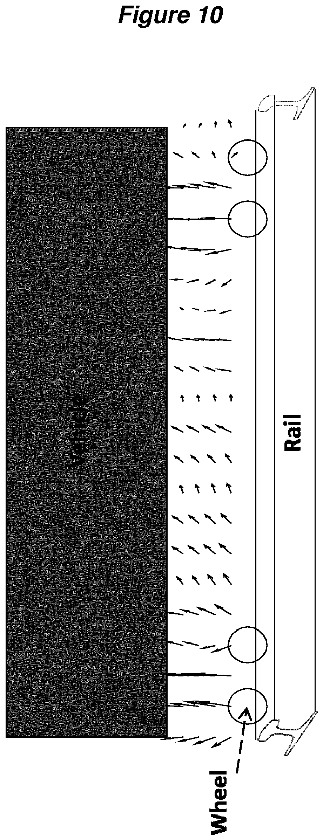

This sound level can then be included as an excitation source for the carbody vibration model, as shown in Figure 10.

Numerical model for carbody vibration

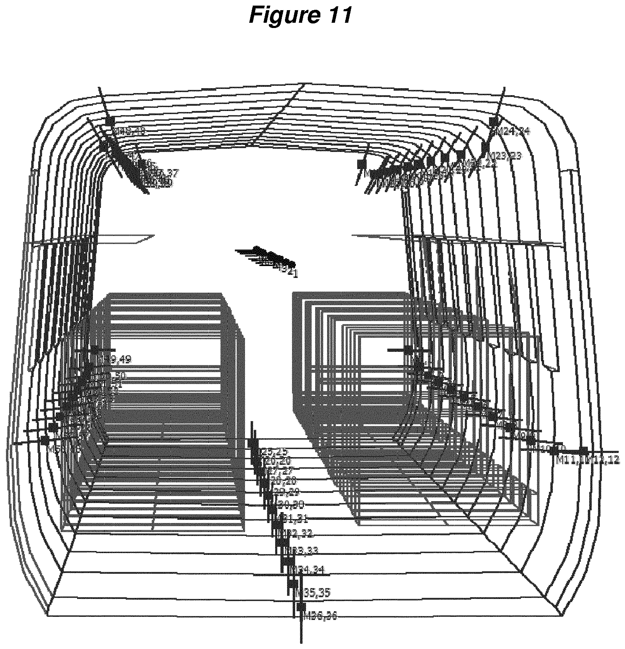

Sound is radiated into the interior of the vehicle by vibration of the carbody. The carriage is modelled in a vibration model to determine how the noise levels are radiated into the vehicle interior. For example, a statistical energy or finite element model may be used. The carbody can be viewed as an array of surface sound sources, as shown in Figure 11. The radiated sound power from these surface sounds sources by the vibration of the carbody can be calculated from external sound level. The noise sources described above are used to excite the sound surface sources of the vibration model to determine how external noise is transmitted to the interior.

Since the ray-tracing models used for acoustic modelling takes sound power as source input, the radiated power of subsystem $i(P^i)$ can be obtained from the external sound power ($W$) and coefficient ($a$):

$$P^i = a_{(f)} W$$

Coefficient a can be decided depending on frequency of the external sound.

The radiated power can be converted to a sound level (SWL) in dB as:

$$SWL = 10 \log_{10} \left( \frac{P^1}{10^{-12}} \right)$$

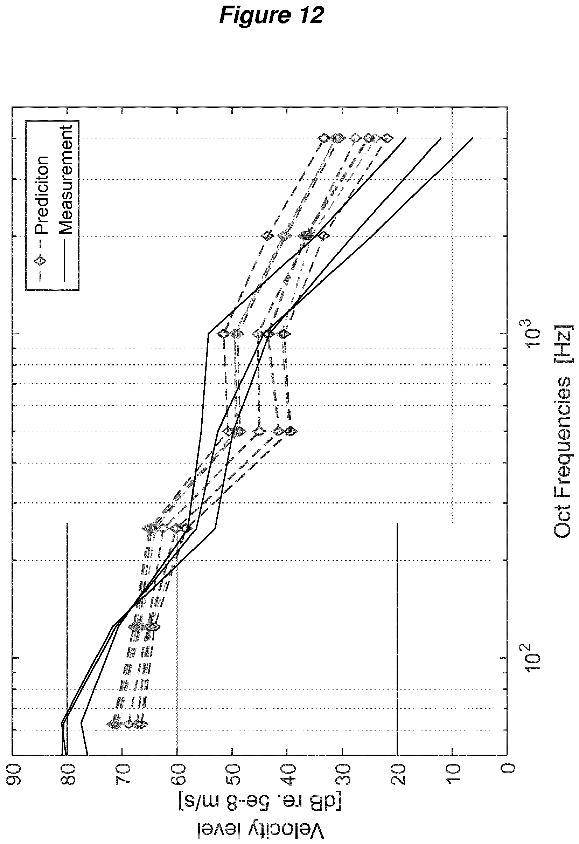

An example of the predicted interior noise levels from the carbody vibration model, and comparison with measurements is shown in Figure 12.

This converted sound in dB may be inputted into ray-tracing model.

Acoustic model of interior

As simplest method, the interior noise level can be estimated from the sound level created based on carbody vibration and a sound attenuation coefficient. The sound attenuation coefficient can be determined using an exchange table, an example of which is shown in Table 2

*Table 2*

| Seat pitch (cm) | 30 | 35 | 40 | 45 |
|---|---|---|---|---|
| Attenuation value | 0.5 | 0.6 | 0.65 | 0.7 |

The interior noise distribution can be estimated using a ray-tracing model. An example of a suitable approach is disclosed, for example, in "Claus Lynge Christensen, Jens Holger Rindel, Environmental Noise Control, The 2005 Congress and Exposition on noise Control Engineering, Predicting Acoustics in Class Rooms", and "Claus Lynge Christensen, Odeon Room Acoustics Program, Version 7.0, User Manual, Industrial, Auditorium and Combined Editions, Odeon A/S, Lyngby, Denmark, August 2004". Modelling techniques such as these can be used to generate acoustic noise distribution maps.

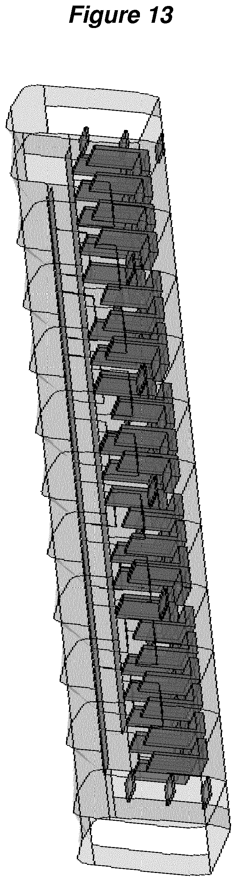

For ray-tracing modelling, the interior lay-out information inputted from the train configurator system is used. General ray-tracing algorithms are used for this invention. A typical input to the ray-tracing algorithm is shown in Figure 13.

The sound absorption coefficients ($\alpha$) of the interior materials, which determine how much energy is absorbed by a surface each time the sound waves are reflected are used to determine the interior noise distribution. Examples based on commonly used materials are shown in Table 3.

*Table 3*

| | 60Hz | 125Hz | 250Hz | 500Hz |
|---|---|---|---|---|
| Floor | 0.09 | 0.09 | 0.08 | 0.21 |
| Seat/Table | 0.25 | 0.25 | 0.36 | 0.47 |
| Interior panel | 0.2 | 0.2 | 0.20 | 0.20 |
| Window | 0.35 | 0.35 | 0.25 | 0.18 |

In addition, estimations may be made for absorption by passengers, luggage and the like. The sound absorption coefficients for different interior features may be determined by measurement of materials, components, or complete interior fixtures, or by simulation of the same.

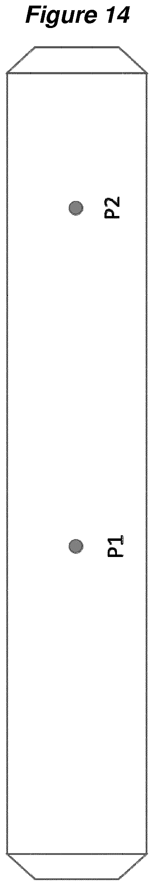

The reverberation time of for a train interior can be used to provide an indication of the acoustic absorption level. This can be calculated by placing sources and receivers at different positions (P1, P2) as shown in Figure 14 and Table 4. The sound pressure decay is calculated to obtain the reverberation time.

*Table 4*

| Source | 60Hz | 125Hz | 250Hz | 500Hz |
|---|---|---|---|---|
| P1 | 0.32 | 0.32 | 0.32 | 0.26 |

(continued)

| Source | 60Hz | 125Hz | 250Hz | 500Hz |
|--------|------|-------|-------|-------|
| P2 | 0.31 | 0.31 | 0.32 | 0.26 |

Noise distribution

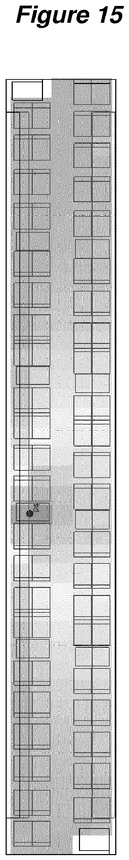

The result of the acoustic model for the interior can then be used to generate a noise distribution for the vehicle interior, an example of which is shown in Figure 15. As described above, the noise distribution may be generated for each configuration, and/or may be generated in advance for default or predetermined rail vehicle configurations. For example, changing the number of seats will change the total absorption area, and shape of their design will impact the sound propagation directions. The effect of these design details on noise level and passenger comfort can be considered and shown accordingly by the present invention.

The noise distribution is used to provide a representation of the acoustic noise of the interior to the user. For example, it may be used to generate an audible or visual representation of the acoustic noise, which may be output via the VR system 200.

Representation

When a "visualize" command is input from one of the parameter input screens, the server selects or generates a representation of the acoustic noise at locations within the rail vehicle, and provides this representation to the user. The representation is preferably an audible representation of the acoustic noise within the rail vehicle, but may alternatively or additionally include a visible representation of the acoustic noise within the rail vehicle.

The representation may additionally include a visual representation of the rail vehicle interior. For example, the server 300 may select visual and/or audible information corresponding to the train configuration information received from the mobile tablet 100, and transmit it to the VR system 200. The exemplary VR system 200 of Figure 1 comprises a headset 210 with a display to show images based on the visual information or acoustic noise model corresponding to the train configuration information, and the head set's location and direction detected by the position sensor 230. It may also show the controller image based on the controller's 220 location and direction detected by the position sensor 230.

The head set 210 may also have speakers to output the modelled noise levels to the user according to selected train configuration, train speed, and user position detected by the position sensor 230.

When a command is inputted from the controller 220 or the tablet 100 to change one or more of the parameters of the train configuration (for example by saving a train configuration, or selecting the "visualize" button of the tablet 100), the server 300 changes the train configuration and visual model, and recalculates the acoustic noise distribution or selects an alternative acoustic noise distribution based on the command information from the controller. The server 300 then transmits the updated image and acoustic noise distribution information for provision to the user.

Design process

A method for designing a rail vehicle interior according to an aspect of the present invention, which uses the system described herein, will now be explained.

The designer uses the configurator to define a rail vehicle or set of rail vehicles with internal dimensions set according to the type of rail vehicle, user selection and the like. The selection made allows the noise levels, e.g. noise levels from rolling noise and/or aerodynamic noise, to be calculated for the acoustic noise distribution. The user may be provided with various default configurations of rail vehicles or rail vehicle components. The inputs to the configurator may be made, for example, by using the tablet 100 or the controller 220 of the VR system 200.

For example, different rail vehicles may be single-decker or double-decker, and may have floors at more than one level within the carriage.

Different rail vehicle types may also have different wheel configurations, such as bogies or fixed wheels, which would affect the rolling noise, in particular during cornering. It may also be possible to configure for different rail gauges, wheel radii and types, and/or suspension types, since this can affect the rolling noise generation and transmission to the vehicle.

Different rail vehicles may also have different aerodynamic profiles, which would affect the aerodynamic noise. The position of a specific rail vehicle within a train will also affect the aerodynamic noise. The dimensions of the rail vehicle will also affect the carbody vibration model, since resonant frequencies and the like will be altered.

The definition of the rail vehicle may also include parameters for noise attenuation by vehicle construction materials (for example thickness of windows and carriage walls, provision of noise dampening materials).

The definition of the rail vehicle may also include parameters for additional external noise sources such as propulsion systems, braking systems and/or ventilation systems, and their location on the rail vehicle. For propulsion systems, this may include propulsion type (e.g. diesel, electric, bi-mode). The definition may also include parameters such as openable windows and/or doors, and location on the rail vehicle. The latter, in particular, will affect the noise attenuation of the rail vehicle, while also acting as a noise source.

The expected noise inputs and attenuation can be determined by simulation, or from (real-world) measurements of stationary and/or moving rail vehicles, e.g. a rail vehicle belonging to a train. If simulated, the simulation may be generated on the basis of other real-world measurements, for example measured acoustic properties of materials and/or components incorporated into the rail vehicle.

Next, the user arranges one or more interior elements (for instance objects or bodies, e.g. fixtures and fittings) selected from the group of seats, benches, tables, flooring or ceiling materials, steps, ramps, or staircases, luggage compartments, bicycle and/or equipment storage, partitions, doors, windows, toilets, catering and/or retail facilities (including, for example, food/drink preparation equipment, refrigerators, display cabinets, point of sale equipment), passenger information/entertainment systems (e.g. speakers, screens, alarms), trash cans, magazine racks, hand rails, poles, hand loops, emergency equipment (e.g. ladders, steps), accessibility equipment (e.g. wheelchair ramps), curtains and/or blinds, prominent bodies such as light fittings, ventilation and/or heating inlets/outlets, power outlets and the like within the defined rail vehicle interior space.

The construction materials for the different interior elements can also be selected. The choice of construction material affects the sound absorption coefficients of the interior elements.

Some of these elements (such as passenger information systems, catering facilities) may also be noise sources for the acoustic model. For example, this may allow the user to test locations of passenger information speakers, alarm systems and the like to ensure that the signals made are suitably audible.

The interior design elements and preferably their location may be used to provide a representation of the acoustic noise distribution for the configured carriage interior. Alternatively the interior design elements and preferably their location may be used to provide a representation of the configured carriage interior and of the noise distribution therein.

Parameters may also be included to account for the background noise generated by passengers, as well as the expected noise attenuation by both passengers and luggage. The passenger and luggage load may also be accounted for by the carbody vibration model, since it will affect at least the noise transmission through the vehicle suspension. The location of passengers and/or luggage within the vehicle may be selected by the user, or may be provided according to predetermined or random passenger distribution profile in combination with a parameter such as a loading proportion.

The user also provides parameters for the simulation. These may be provided as default settings, set in advance, or set by the user prior to each execution of the simulation. The parameters include, for example, observation position (or starting position, if the simulation is configured to allow the user to "move" within the simulated space). Various parameters may also be set for the rail vehicle operation, such as current speed, whether the track is straight or curved, propulsion type and load, braking system and load, wheel-slip, ventilation/heating system load, open/closed status of doors and windows, use of catering/retail equipment, passenger announcements or alarms, and passenger/luggage load in the vehicle. Environmental noises, including weather, passing trains, and echoes from tunnels and/or surrounding buildings may also be selected. Interior and/or exterior air temperature, pressure and/or humidity, which will affect at least the aerodynamic noise of the train and the interior noise propagation may also be configured.

The simulation is generated by the server 300 according to the chosen parameters and output to the user. At least a representation of the simulated acoustic noise distribution is output. This may be either an audible or visual representation of the acoustic noise distribution. A visual representation of the rail vehicle interior may additionally be provided such that the user can experience a more complete simulation of the configured rail vehicle, and the likely passenger experience. The simulation may be provided to the user via the VR system 200, or by other means of audible and/or visual output.

The user can modify the parameters of the rail vehicle, arrangement of interior elements, or simulation parameters as required, providing a means for comparison between different configurations and situations in terms of the resultant noise distributions. Accordingly, they are able to design a rail vehicle interior with a more complete understanding of the effect of design parameters on the expected passenger experience.

The features disclosed in the foregoing description, or in the following claims, or in the accompanying drawings, expressed in their specific forms or in terms of a means for performing the disclosed function, or a method or process for obtaining the disclosed results, as appropriate, may, separately, or in any combination of such features, be utilised for realising the invention in diverse forms thereof.

While the invention has been described in conjunction with the exemplary embodiments described above, many equivalent modifications and variations will be apparent to those skilled in the art when given this disclosure. Accordingly, the exemplary embodiments of the invention set forth above are considered to be illustrative and not limiting. Various changes to the described embodiments may be made without departing from the spirit and scope of the invention.

For the avoidance of any doubt, any theoretical explanations provided herein are provided for the purposes of improving the understanding of a reader. The inventors do not wish to be bound by any of these theoretical explanations.

Any section headings used herein are for organizational purposes only and are not to be construed as limiting the subject matter described.

Throughout this specification, including the claims which follow, unless the context requires otherwise, the word "comprise" and "include", and variations such as "comprises", "comprising", and "including" will be understood to imply the inclusion of a stated integer or step or group of integers or steps but not the exclusion of any other integer or step or group of integers or steps.

It must be noted that, as used in the specification and the appended claims, the singular forms "a," "an," and "the" include plural referents unless the context clearly dictates otherwise.

**Claims**

1. A method of designing the interior arrangement of a rail vehicle, the method comprising the steps of:

   providing a simulated rail vehicle with an interior space;
   arranging one or more simulated elements within the interior space;
   providing an acoustic noise distribution for the interior space on the basis of at least the simulated elements and their arrangement within the interior space;
   providing a representation of the acoustic noise at one or more locations within the interior space.

2. A method of designing the interior arrangement of a rail vehicle according to claim 1, and further comprising the step of:

   providing a model of one or more sources of acoustic noise;
   wherein the step of providing the acoustic noise distribution includes the step of generating the acoustic noise distribution for the interior space on the basis of at least the model, the simulated interior elements and their arrangement within the interior space.

3. A method of designing the interior arrangement of a rail vehicle according to claim 1 or 2, and further comprising the steps of:

   selecting a location within the interior space;
   providing the representation of the acoustic noise at the selected location.

4. A method of designing the interior arrangement of a rail vehicle according to any one of claims 1 to 3, wherein:
   the provided representation of the acoustic noise is an audible representation or a visual representation, or both an audible and a visual representation.

5. A method of designing the interior arrangement of a rail vehicle according to claim 4, wherein:
   the provided representation further includes a visual representation of at least the interior space, the simulated elements, and their arrangement.

6. A method of designing the interior arrangement of a rail vehicle according to any one of claims 2 to 5, wherein:
   the one or more sources of acoustic noise may be external to the interior space, or internal to the interior space.

7. A method of designing the interior arrangement of a rail vehicle according to claim 6, wherein:
   the transmission of acoustic noise from sources that are external to the interior into the interior space is modelled via a carbody vibration model.

8. A method of designing the interior arrangement of a rail vehicle according to claim 7, wherein:
   the acoustic noise distribution for the interior space is calculated via a ray-tracing method based on the carbody vibration model for acoustic noise sources external to the interior space and/or one or more acoustic noise sources internal to the interior space.

9. A method of designing the interior arrangement of a rail vehicle according to claim 8, wherein:
   the ray-tracing method utilises one or more sound absorption coefficients corresponding to the one or more simulated interior elements.

**10.** A method of designing the interior arrangement of a rail vehicle according to claim 9, wherein:
the one or more sound absorption coefficients have different values depending on the frequency of the acoustic noise.

**11.** A method of designing the interior arrangement of a rail vehicle according to claim 9 or 10, wherein:
the acoustic noise distribution is further based on one or more sound absorption coefficients for aside from those for the one or more simulated interior elements.

**12.** A method of designing the interior arrangement of a rail vehicle according to any one of claims 2 to 11, wherein:
the volume and/or frequency of the one or more sources of acoustic noise can be changed.

**13.** A method of designing the interior arrangement of a rail vehicle according to any one of claims 9 to 12, wherein:
the acoustic noise distribution and/or models of one or more sources of acoustic noise and/or one or more sound absorption coefficients are based on representative measured data of rail vehicles and/or fixtures and fittings and/or construction materials thereof.

**14.** A system for designing the interior arrangement of a rail vehicle, comprising:

input means operable to arrange one or more simulated elements within an interior space of a simulated rail vehicle;
a processor configured to provide an acoustic noise distribution for the interior space based on the simulated elements and their arrangement within the interior space, and on a model of one or more sources of acoustic noise;
input means operable to select a location within the interior space;
output means configured to provide a representation of the acoustic noise at the selected location.

**15.** A system for designing the interior arrangement of a rail vehicle according to claim 14, wherein:

the provided representation of the acoustic noise is an audible representation or a visual representation, or both an audible and a visual representation; and wherein
the provided representation further includes a visual representation of at least the interior space, the simulated elements, and their arrangement.

# Figure 1

## Figure 2

## Figure 3

EP 3 663 943 A1

405 407 408 409

Load/Save ▼    Train layout ▼    Standard Class ▼    First Class ▼    

Visualize

406

Carriage 1: Standard class    Carriage 2: Standard class

401

403

402

Cost ●●●○○    Comfort ●●●●○    Cost ●●●○○    Comfort ●●●○○

Delivery time ●●○○○    Cleaning Efficiency ●●●○○    Delivery time ●●●○○    Cleaning Efficiency ●●●○○

Profitability ●●●○○    Seat pitch 860 mm    Profitability ●●○○○    Seat pitch 860 mm

| Platform | Length | Seating | Cost | Delivery Time | Profitability | Comfort | Cleaning Efficiency | Noise |
|---|---|---|---|---|---|---|---|---|
| Intercity | 6 cars/120.7m | 238 | ●●●○○ | ●●○○○ | ●●●○○ | ●●●○○ | ●●●○○ | ●●●●○ |

404

*Figure 4*

## Figure 5

# Figure 6

## Figure 7

## Figure 8

# Figure 9

*Figure 10*

# Figure 11

# Figure 12

# Figure 13

## Figure 14

# Figure 15

Europäisches
Patentamt

European
Patent Office

Office européen
des brevets

# EUROPEAN SEARCH REPORT

Application Number

EP 18 21 1171

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2018/232471 A1 (SCHISSLER CARL HENRY [US] ET AL) 16 August 2018 (2018-08-16) * paragraph [0002] * * paragraph [0029] - paragraph [0031] * * paragraph [0064] * * paragraph [0069] * ----- | 1-15 | INV. G06F17/50 |
| X | DE 10 2010 043368 A1 (AIRBUS OPERATIONS GMBH [DE]) 10 May 2012 (2012-05-10) * paragraph [0005] * * paragraph [0011] * * paragraph [0045] - paragraph [0049] * ----- | 1-15 | |
| X | US 6 088 521 A (STRUMOLO GARY STEVEN [US] ET AL) 11 July 2000 (2000-07-11) * the whole document * ----- | 1-15 | |

TECHNICAL FIELDS
SEARCHED      (IPC)

G06F

The present search report has been drawn up for all claims

| Place of search | Date of completion of the search | Examiner |
|---|---|---|
| Munich | 26 April 2019 | Hanon, David |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 18 21 1171

This annex lists the patent family members relating to the patent documents cited in the above-mentioned European search report.
The members are as contained in the European Patent Office EDP file on
The European Patent Office is in no way liable for these particulars which are merely given for the purpose of information.

26-04-2019

| Patent document cited in search report | Publication date | Patent family member(s) | Publication date |
|---|---|---|---|
| US 2018232471 A1 | 16-08-2018 | NONE | |
| DE 102010043368 A1 | 10-05-2012 | DE 102010043368 A1<br>US 2012116736 A1 | 10-05-2012<br>10-05-2012 |
| US 6088521 A | 11-07-2000 | DE 19919891 A1<br>GB 2340275 A<br>US 6088521 A | 09-03-2000<br>16-02-2000<br>11-07-2000 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20070233433 A
- US 20160110916 A
- US 20090216502 A

**Non-patent literature cited in the description**

- **THOMPSON, D J. ; RAILWAY NOISE.** Vibration - Mechanism Modelling and Means of Control. Elsevier, 2009
- **KITAGAWA T ; THOMPSON D J.** The horizontal directivity of acoustic noise radiated by a rail and implications for the use of microphone arrays. *Journal of Sound and Vibration,* 18 January 2010, vol. 329 (2